(19) Europäisches Patentamt

European Patent Office

Office européen des brevets

(11) **EP 0 446 408 B1**

(12) **EUROPÄISCHE PATENTSCHRIFT**

(45) Veröffentlichungstag und Bekanntmachung des Hinweises auf die Patenterteilung:
**30.07.1997   Patentblatt 1997/31**

(51) Int Cl.⁶: **H01Q 17/00**

(21) Anmeldenummer: **90116704.9**

(22) Anmeldetag: **31.08.1990**

(54) **Reflexionsarmes Wandelement für Radarstrahlung**

Wall element minimizing radar reflections

Elément de paroi minimalisant les réflexions radar

(84) Benannte Vertragsstaaten:
**AT BE CH DE ES FR GB IT LI LU NL**

(30) Priorität: **12.03.1990  DE 4007807**

(43) Veröffentlichungstag der Anmeldung:
**18.09.1991   Patentblatt 1991/38**

(73) Patentinhaber: **TRUBE & KINGS KG**
**D-56767 Uersfeld (DE)**

(72) Erfinder: **Möller, Erhard, Prof. Dr.-Ing.**
**D-5100 Aachen (DE)**

(74) Vertreter: **Patentanwälte Dr. Solf & Zapf**
**Candidplatz 15**
**81543 München (DE)**

(56) Entgegenhaltungen:
EP-A- 0 394 732          DE-B- 2 715 823
DE-C- 1 036 333          DE-C- 1 116 285
GB-A- 581 746            US-A- 4 327 364

- **PATENT ABSTRACTS OF JAPAN** Band 7, Nr. 115
  (E-176)(1260), 19. Mai 1983; & JP - A - 58034602
  (**TOKYO DENKI KAGAKU KOGYO**) 01.03.1983
- Revue X Tijdschrift, Nr. 3, 1086, Bruxelles BE,
  Seiten 1-7, M. Piette, "Revetement Interferentiel
  pour char à 35 et 94 GHz".

## Beschreibung

Die vorliegende Erfindung betrifft ein reflexionsarmes Wandelement für Radarstrahlung aus mindestens **n**=2 oder geradzahligen Vielfachen von **n** bestehenden Teilflächen, deren Länge und Breite größer sind als die Wellenlänge der Radarstrahlung und die zueinander einen derartigen Tiefenversatz besitzen, daß sich die von den Teilflächen reflektierten Radarsignale durch Interferenz völlig bzw. weitgehend aufheben.

Bedingt durch das höhere Verkehrsaufkommen im Flugverkehr steigt der Bedarf an Gebäuden und Bauwerken auf und in der Nähe von Flughäfen. Die Oberflächen dieser Gebäude wirken für das Flughafenradar als Reflektoren, die die Radarstrahlen umlenken und auf dem Radarschirm des Fluglotsens als Spiegelziele erscheinen lassen. So entstehen beispielsweise aufgrund dieser Reflexionen eines signifikanten Gebäudes am Frankfurter Flughafen bis zu 50 Spiegelziele am Tag. In Düsseldorf treten in gleicher Art bis zu 57 Spiegelziele auf. Die durch die Reflexion entstandenen Spiegelziele auf dem Radarbildschirm unterscheiden sich von den Echtzielen durch Azimut und Entfernung. Die Sicherheit des Luftverkehrs und die optimale Nutzung des Luftraumes sind von diesem Phänomen betroffen, da die Spiegelziele zu falschen Informationen und weiteren Beeinträchtigungen wie verminderte Qualität des Radarbildes, teilweiser Verlust von Echtzielen, erhöhte Abfrageraten bei den Sekundär-Transpondern und beeinträchtigte Spürgüte führen.

Zur Reduzierung der Radarreflexion an den Gebäudeflächen sind mehrere Methoden bereits bekannt. So ist es bekannt, absorbierende Baumaterialien zur Herstellung der Fassade als Fassadenbeläge oder als Wandelemente zu verwenden. Hierzu werden beispielsweise 5 mm dicke Farbbeschichtungen oder Kachelbeläge verwendet. Diese Beschichtungen oder Kacheln bestehen aus verlustbehafteten Werkstoffen auf Kohlenstoff- oder Ferritbasis. Die Kosten für derartige Beläge sind aber im Vergleich zu üblichen Fassadenverkleidungen sehr hoch. Auch kann Gasbeton als absorbierendes Baumaterial verwendet werden, und zwar Gasbeton mit einer Dichte < 0,6 kg/dm$^3$. Da die genannten Materialien nicht wetterfest sind, werden sie in der Regel mit dünnen Schutzschichten versehen. Der Einfluß des Reflexionsfaktors durch diese Schutzschichten muß dabei aber beachtet werden. Zudem sind die Einflüsse durch Wetter und Umwelt, die zu feuchten und verschmutzten Oberflächen führen, wodurch die Oberflächenwiderstände reduziert werden, auf das Reflexionsverhalten nicht abzuschätzen.

Weiterhin ist es bekannt, sogenannte radar-transparente Fassaden zu verwenden. Derartige Fassaden reflektieren nicht die Radarwelle, sondern lassen sie in das Gebäude eindringen, wobei davon ausgegangen wird, daß die Radarwelle dann innerhalb des Gebäudes diffus reflektiert wird. Bei derartigen radartransparenten Fassaden muß aber sichergestellt sein, daß nicht hinter der Fassadenfläche innerhalb des Gebäudes Reflexionsflächen wiederum vorhanden sind. Wie dies beispielsweise bei Flugzeughallen durch die in den Hallen stehenden Flugzeuge der Fall ist. Derartige radar-transparente Fassaden können aus Holz oder aus Kunststoffen bestehen. Wegen der leichten Entflammbarkeit dieser Baustoffe scheidet deren Verwendung häufig aus Gesichtspunkten des Brandschutzes aus. Da Glas- und Zementfasern nur als teiltransparent und teilreflektierend anzusehen sind, können sie für derartige transparente Fassaden nur bedingt eingesetzt werden. Zudem können durch Wetter- und Umwelteinflüsse auf der Außenhaut der Fassade Ablagerungen entstehen, die die Transparenz der Fassade verändern.

Auch ist es bereits bekannt, die Fassade derart zu strukturieren, daß sie aus einer Vielzahl kleiner Flächen mit unterschiedlicher Ausrichtung besteht, so daß diffuse Reflexionen und Abschattungen erzeugt werden. Hierdurch wird der Radar-Rückstreuquerschnitt der gesamten Fassade reduziert. Auch hier können Wetter- und Umwelteinflüsse die Reflexionseigenschaften ungünstig beeinflussen, zudem wird durch diese Strukturierung die architektonische Gestaltung der Fassade sehr eingeschränkt.

Eine weitere Lösung besteht in dem Aufbau mehrschichtiger Fassaden, so daß durch den mehrschichten Aufbau eine Reflexionsreduzierung der Radarwellen nach dem Prinzip der Resonanzabsorber erreicht wird. Die Verwendbarkeit derartiger Fassaden ist deshalb begrenzt, da auch hier Wetter- und Umwelteinflüsse, insbesondere Feuchtigkeit und Schmutz, das Reflexionsverhalten der äußeren Schicht verändern, aber die zweite Grenzschicht und deren Einfluß auf das Reflexionsverhalten unverändert lassen.

In dem Artikel von M. Piette "Revetement Interferentiel pour char à 35 et 94 GHz" in der Revue X Tijdschrift, Nr. 3, 1086, Bruxelles BE, Seiten 1-7 wird eine Radar-Tarnung von Panzern betrachtet. Die Panzerwand ist zur Erzeugung von Interferenzerscheinungen mit einem Wandelement der eingangs beschriebenen Art versehen. Im Gegensatz zu dem oben beschriebenen Problem der Entstehung von Spiegelzielen wird in der Veröffentlichung jedoch ausschließlich die Strahlengang vom Radargerät zum Panzer und zurück betrachtet. D.h. es handelt sich um eine Nebenreflexion in Einfallsrichtung, die von Natur aus eine kleinere Amplitude als die Hauptreflexion aufweist, bei welcher der Strahl in einem dem Einfallswinkel gleich großen Ausfallswinkel reflektiert wird. Die kleinere Amplitude von aufgrund von Nebenreflektionen zurückgeworfener Strahlung ist leichter zu dämpfen als die Amplitude einer Strahlung aus der Hauptreflexion. Der Artikel beschreibt zur Tarnung eines Panzers nur eine technische Lösung für den lotrechten Einfall des Radarstrahls auf die Panzeroberfläche.

Auch in der GB-A- 581 746 wird die Radar-Tarnung von Objekten, insbesondere Flugzeugen, betrachtet. Ein großer Teil der Außenhaut eines solchen Objektes ist zu diesem Zweck mit einem Versatz von Vorsprüngen und Vertiefungen versehen, deren Oberflächen einen derartigen Abstand zueinander besitzen, daß sich die jeweiligen an ihnen reflektierten Strahlungsanteile in großem Maß durch Interferenz miteinander auslöschen. Dazu soll der Abstand der Oberflächen einer Viertelwellenlänge der Radarstrahlung entsprechen, was jedoch nur bei lotrechtem Einfall des Radarstrahls zu einer befriedigenden Strahlungsauslöschung führt.

In der nachveröffentlichten EP-A-0 394 732 ist eine Außenwand für ein in der Nähe eines Radars stehendes Bauwerk beschrieben. Es wird vorgeschlagen, zur Verminderung der Reflexion von Radarstrahlung an störenden Gebäudewänden bei der Radarüberwachung am Boden die Außenwände bzw. Wandelemente der Außenwände so zu gestalten, daß die reflektierten Radarwellen teilweise eine Phasenverschiebung von einer halben Wellenlänge zueinander aufweisen. Dadurch tritt eine teilweise Auslöschung der reflektierten Wellen ein. Die reflektierende Oberfläche der Außenwand besteht zu diesem Zweck aus einzelnen Segmenten, deren Flächenausdehnung kleiner ist als die von einem Radarimpuls ausgeleuchtete Fläche, und die in der Tiefe derart gestaffelt sind, daß jeweils zwei benachbarte Flächensegmente um einen Abstand voneinander entfernt angeordnet sind, der einer Viertelwellenlänge der verwendeten Radarstrahlung entspricht.

Der vorliegenden Erfindung liegt die Aufgabe zugrunde, ein für Radarstrahlung reflexionsarmes Wandelement der eingangs beschriebenen Art zu schaffen, das einerseits eine zuverlässige Vermeidung von Reflexionen von unter unterschiedlichem Winkel einfallender Radarstrahlung ermöglicht und andererseits in seiner Wirkung unabhängig ist von Wetter- und Umwelteinflüssen sowie für Gebäude eine weitgehend vielfältige Ausgestaltung zuläßt.

Erfindungsgemäß wird dies mit einem reflexionsarmen Wandelement für Radarstrahlung der eingangs beschriebenen Art erreicht, bei dem die Teilflächen derart ausgebildet sind, daß sie einen gleich großen äquivalenten Radarrückstreuquerschnitt besitzen und der Tiefenversatz t sich berechnet aus

$$t = \frac{\lambda}{4\cos\Phi}$$

wobei λ die Wellenlänge der Radarstrahlung und Φ der Einfallswinkel der Radarstrahlung in der horizontalen Ebene auf die Teilflächen ist, und das Wandelement Bestandteil einer Gebäudefassade ist.

Die Reflexionsarmut bzw. Reflexionsfreiheit dieses erfindungsgemäßen Wandelementes bzw. einer aus dem erfindungsgemäßen Wandelement aufgebauten Fassadenfläche beruht bekanntermaßen auf dem Interferenzprinzip, wobei sich die Reflexionen zweier benachbarter Teilflächen bzw. Segmente auslöschen bzw. derart schwächen, daß sie unter einem bestimmten Grenzwert liegen, der noch als störendes Spiegelbild auf dem Radarschirm erkennbar wäre. Eine Wetter- und Umweltabhängigkeit besteht nicht, da Wetter- und Umwelteinflüsse auf die Teilflächen in gleicher Weise einwirken. Vorteilhafterweise sind die reflektierenden Oberflächen der Teilflächen bzw. Segmente erfindungsgemäß in parallelen Ebenen mit einem Tiefenversatz angeordnet, der einerseits von der Wellenlänge der Radarstrahlung und andererseits in genau definierter geeigneter Weise vom Einfallswinkel der Radarstrahlung in horizontaler Ebene abhängt. Somit läßt sich durch eine geometrische Aufgliederung der gesamten Gebäudefassade in Abhängigkeit von dem Einfallwinkel der Radarstrahlen eines stationären Radars der Versatz der einzelnen reflexionswirksamen Teilflächen berechnen. Auf der Basis einer Radarstrahlung mit einer Wellenlänge von λ = 30 cm und einem Einfallswinkel Φ von 0° ergibt sich somit ein Tiefenversatz der parallelen reflektierenden Teilflächen von t = 7,5 cm. Die erfindungsgemäße Lehre basiert hierbei auf folgenden Randbedingungen und Voraussetzungen:

1. Die Entfernung zwischen der reflektierenden Fassade und dem Radargerät bzw. dem Radarziel ist groß gegenüber den Abmessungen des Gebäudes und den Abmessungen der Teilflächen.

2. Die Fassade wird von einer ebenen Welle getroffen,

3. die Radarwelle ist vertikal polarisiert,

4. die Amplituden der elektrischen und magnetischen Feldstärken sind in der Fassadenebene ortsunabhängig.

Vorteilhafte Ausführungsformen der Erfindung sind in den Unteransprüchen enthalten. Anhand der in den beiliegenden Zeichnungen dargestellten Ausführungsbeispiele wird die Erfindung näher erläutert.

Es zeigen:

Fig. 1        eine Prinzipansicht eines ersten erfindungsgemäßen Wandelements,

Fig. 2        eine Prinzipansicht einer weiteren Ausführungsform eines erfindungsgemäßen Wandelements,

Fig. 3        eine Prinzipansicht einer mit dem Wandelement gemäß Fig. 1 aufgebauten Fassadenfläche,

Fig. 4 bis 6      Ansichten bzw. Schnitte von Ausführungsbeispielen der Erfindung.

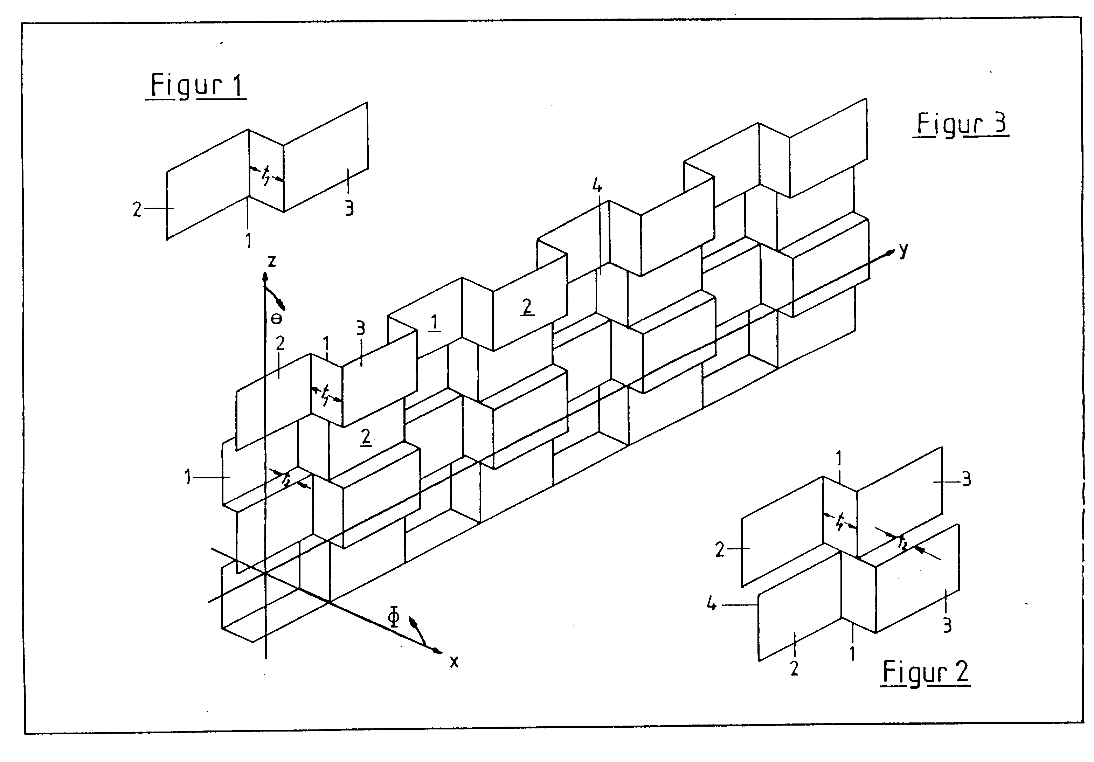

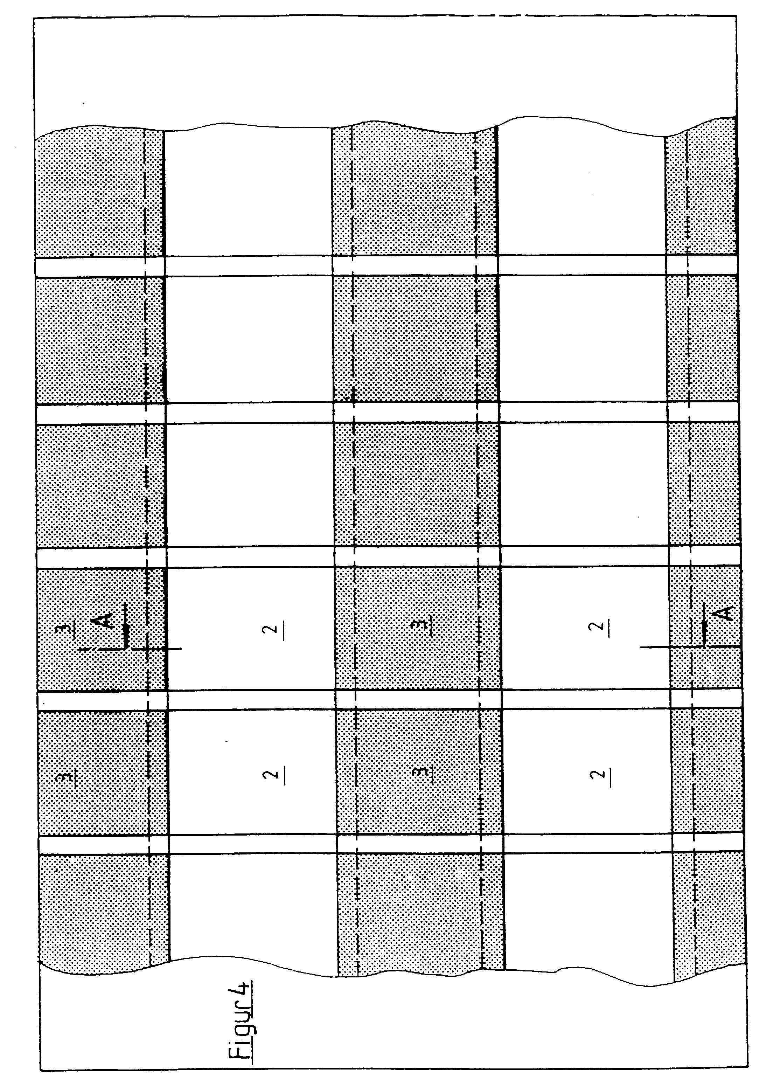

Wie sich aus Fig. 1 ergibt, besteht ein erfindungsgemäßes reflexionsarmes Wandelement 1 aus zwei Teilflächen 2, 3, deren Oberflächen Reflexionsflächen für ein auftreffendes Radarsignal bzw. für eine auftreffende Radarstrahlung bilden. Das Wandelement 1 bildet somit eine Spiegelzeile. Die beiden Teilflächen 2, 3, bzw. deren reflektierende Oberflächen liegen auf parallelen Ebenen, die gegeneinander um einen Tiefenversatz $t_1$ zueinander versetzt angeordnet sind. Dieser Tiefenversatz $t_1$ ist abhängig von der Wellenlänge $\lambda_1$ eines nicht dargestellten ersten Radarstrahlers, dessen Radarstrahlung unter einem bestimmten Einfallwinkel $\Phi_1$ auf die Teilflächen 2, 3 auftrifft. Der Tiefenversatz $t_1$ ist erfindungsgemäß nun derart gewählt, daß die an den beiden Teilflächen 2, 3 reflektierten Radarstrahlen aufgrund von Interferenz sich aufheben bzw. sich derart schwächen, daß das reflektierte Signal einen Grenzwert unterschreitet, der derart gewählt ist, daß er auf dem Radarempfänger kein störendes Spiegelbild mehr erzeugt bzw. von dem Radarempfänger unterdrückt werden kann. Unter der Annahme, daß in vertikaler Richtung der Radarstrahlung, siehe Fig. 3, in der die Koordinaten und Einfallwinkel eingezeichnet sind, die Radarstrahlung senkrecht einfällt, ergibt sich eine Abhängigkeit des Tiefenversatzes $t_1$ einerseits von der Wellenlänge $\lambda_1$ des Radarstrahlers und andererseits von dem Cosinus des Einfallwinkels $\Phi_1$ in der horizontalen Ebene, insbesondere gilt die Beziehung

$$t_1 = \frac{\lambda_1/4}{\cos \Phi_1}$$

Die beiden Teilflächen 1 und 2 sind vorzugsweise derart befestigt, daß sie gegeneinander elektrisch isoliert sind.

Die reflektierende Schicht der Teilflächen 1, 2 besteht vorzugsweise aus einem metallischen Material. Die Teilflächen 1, 2 können erfindungsgemäß metallisch beschichtet sein oder aber können eine Metallfolie aufweisen. Es ist ebenfalls möglich, wenn die Teilflächen insgesamt aus einer Metallplatte gebildet sind. Weiterhin liegt es im Rahmen der Erfindung, wenn die reflektierende Schicht der Teilflächen 1, 2 aus einem Metallgitter oder einer Metallmaschenstruktur gebildet ist, wobei die Gitterspalte bzw. die Maschenweite ≤ 1/10 $\lambda_1$ betragen. Mit der erfindungsgemäßen Spiegelzeile 1 läßt sich somit durch entsprechend gewählten Tiefenversatz $t_1$ Reflexionen in oder aus vorgegebener Richtung ausblenden. Hierbei liegt es weiterhin im Rahmen der Erfindung, daß durch die Wahl der Breite jedes Flächenelementes 2, 3 auch weitere Strahlungsrichtungen, beispielsweise eines zweiten Radarstrahlers, der gegenüber dem ersten Radarstrahler unter einem anderen Einfallwinkel das erfindungsgemäße Wandelement anstrahlt, ausgeblendet werden können.

In Fig. 2 ist ein weiteres erfindungsgemäßes reflexionsarmes Wandelement als Spiegelspalte 4 dargestellt. Diese Spiegelspalte 4 besteht aus zwei in Fig. 1 beschriebenen Spiegelzeilen 1, die übereinander angeordnet sind, und zwar derart, daß zwischen den beiden Spiegelzeilen 1 ein Tiefenversatz $t_2$ der parallelen Teilflächen 2,2 und 3,3 der Spiegelzeilen 1 zueinander gegeben ist, wobei sich dieser Tiefenversatz $t_2$ in Abhängigkeit von der Wellenlänge der Radarstrahlung eines zweiten, nicht dargestellten Radarstrahlers ergibt und dem horizontalen Einfallwinkel $\Phi_2$ der Radarstrahlung dieses zweiten Radarstrahlers auf die Teilflächen 2, 3. Somit ist es mit dieser erfindungsgemäßen Ausführungsform eines Wandelementes möglich, die Radarstrahlung zweier unterschiedlicher Radarstrahler aufzuheben bzw. derart auszublenden, daß die Reflexionen einen bestimmten Grenzwert nicht überschreiten. Der Aufbau und die Anordnung der einzelnen Teilflächen 2, 3 erfolgt zweckmäßigerweise entsprechend der Beschreibung zu Fig. 1.

In Fig. 3 ist eine aus den erfindungsgemäßen Wandelementen gemäß Fig. 1 bzw. gemäß Fig. 2 aufgebaute Wandfläche im Prinzip dargestellt. Hierbei ist eine beliebige Erweiterung der Wandfläche in allen Richtungen möglich. Weiterhin ist aus Fig. 3 die horizontale X-Y-Ebene und der horizontale Einfallwinkel $\Phi$ zu erkennen sowie die senkrechte Y-Z-Ebene mit dem Einfallwinkel $\theta$.

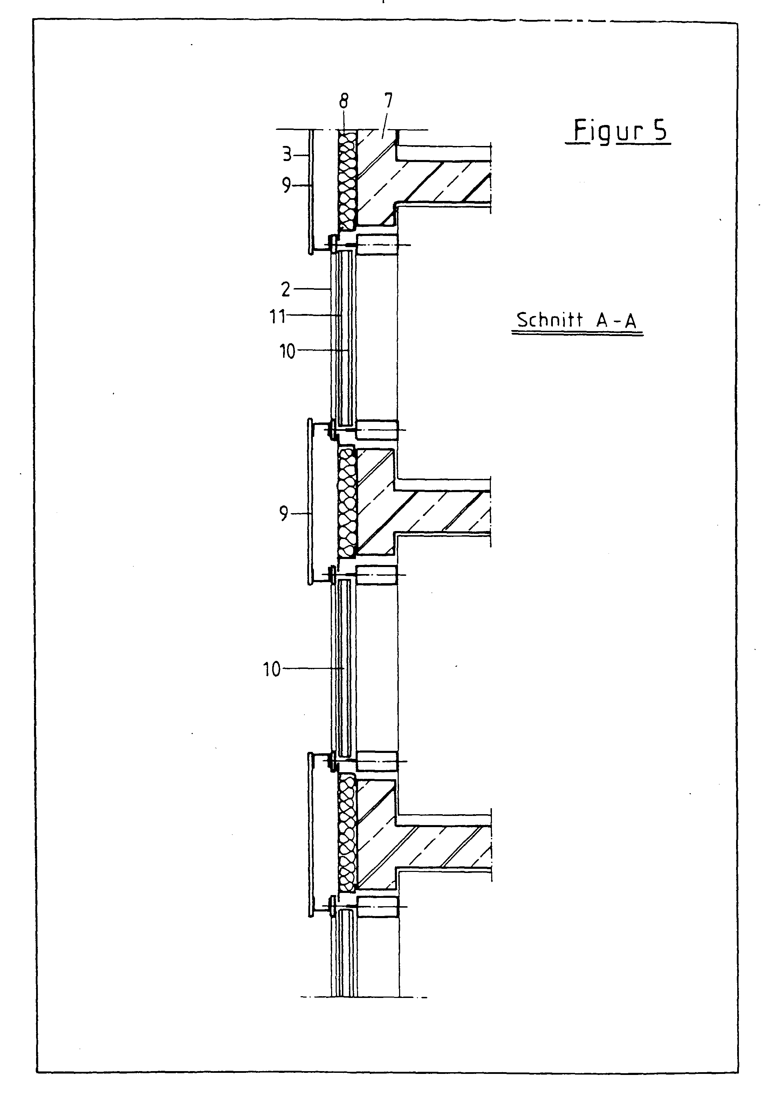

In Fig. 4 ist die Ansicht eines Fassadenabschnittes dargestellt, der wiederum in Teilflächen gemäß der Ausgestaltung einer Spiegelzeile gemäß Fig. 1, und zwar in die Teilflächen 2 und 3 unterteilt ist. Diese Teilflächen 2 und 3 haben, wie aus Fig. 5 ersichtlich ist, einen Versatz $t_1$. Hierbei bilden die Teilflächen 3 den Abschnitt der Fassade, der als Mauerwerk ausgebildet ist, so daß dieser Teil öffnungslos ist. Die Teilflächen 2 stellen den Teil der Fassade dar, der als Fenster ausgebildet ist. Um nun den Teilflächen 2, 3 das gewünschte Reflexionsverhalten zu geben, ist die in Fig. 5 vorteilhafte Ausbildung gewählt. Wie hieraus zu erkennen ist, ist zur Bildung der Teilfläche dem Mauerwerk 7, das beispielsweise noch an seiner Vorderseite mit einer Wärmeisolation 8 versehen sein kann, eine Verblendung 9 vorgesetzt, die die Teilfläche 3 als Reflexionsfläche bildet. Diese Verblendung 9 kann aus einer metallbeschichteten Platte bestehen oder aber sie kann auch als Glasscheibe ausgebildet sein, die auf ihrer Innenseite metallbeschichtet ist. Im dargestellten Ausführungsbeispiel werden die Fenster 10 aus Doppelscheiben gebildet, wobei die äußere Scheibe 11 an ihrer Innenseite eine Metallbeschichtung aufweist. Die Verblendung 9 ist gegenüber der Scheibe 11 des Fensters 10 um den jeweils in Abhängigkeit von dem Einfallwinkel der Radarstrahlung und der Wellenlänge der Radarstrahlung abhängigen Tiefenversatz $t_1$ versetzt, der erforderlich ist, um die gewünschte Ausblendung der Abstrahlung zu erreichen.

In Fig. 5 sind die gleichnamigen Teilflächen 3 in horizontaler Anordnung nebeneinander und die Teilflächen 2 ebenfalls in horizontaler Anordnung nebeneinander angeordnet. Es liegt ebenfalls im Rahmen der Erfindung, die gleichnamigen Teilflächen 3 und die gleichnamigen Teilflächen 2 jeweils in vertikaler Folge untereinander bzw. übereinander anzuordnen. Ebenfalls ist es möglich, eine Schachbrettartige Anordnung der Teilflächen 2 und 3 zueinander vorzusehen.

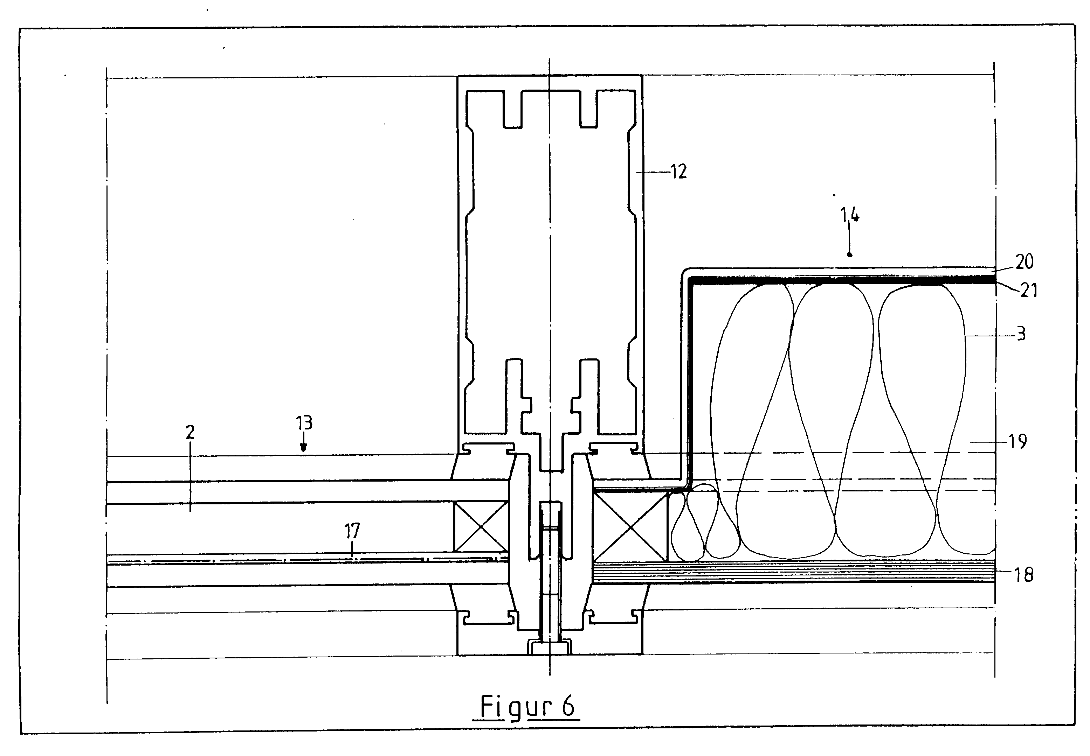

In Fig. 6 ist ein weiteres Ausführungsbeispiel gezeigt, und zwar an einer Fassade, bestehend aus einer Stütze 12, wobei Fensterabschnitte 13 und geschlossene Abschnitte 14 vorgesehen sind.

Erfindungsgemäß bilden nunmehr die Abschnitte 13, 14 die erfindungsgemäßen Teilflächen 2, 3 einer Spiegelzeile. Hierzu ist der Fensterabschnitt 13 mit einem Doppelfenster verschlossen, wobei die äußere Fensterscheibe 16 eine Innenbeschichtung 17 aufweist, die aus einer metallischen Beschichtung besteht und für die auftreffende Radarstrahlung reflektierende Eigenschaften besitzt. Der geschlossene Fensterabschnitt 14 besteht aus einer vorderen Verblendung 18 und einer hinter der Verblendung 18 angeordneten Füllung 19 aus Isoliermaterial sowie einem hinteren Schalenelement 20. Dieses Schalenelement 20 ist auf seiner Vorderseite mit einer reflektierenden Beschichtung 21 versehen, die für die Radarstrahlung Reflexionseigenschaften besitzt. Die Innenbeschichtung 17 der Fensterscheibe 16 sowie die Beschichtung 21 der Schale 20 sind um einen derartigen Tiefenversatz $t_1$ zueinander versetzt, wie dies für die Auslöschung der Radarstrahlung gemäß dem zu Fig. 1 erläuterten Prinzip erforderlich ist.

Bei den üblichen Fassaden mit üblichen Geschoßhöhen ist es zweckmäßig, wenn die Teilflächen 2, 3 beispielsweise eine Höhe von ca. 1,50 m und eine Breite von 3 m besitzen.

Das vorstehend beschriebene erfindungsgemäße Prinzip dient dazu, das beispielsweise von einem Flugobjekt, einem Flugzeug, erzeugte, reflektierte Radarsignal an der Fassade derart zu reflektieren, daß durch Interferenz eine Auslöschung in der Reflexionsrichtung erfolgt.

Erfindungsgemäß ist es weiterhin möglich, ein erfindungsgemäßes Wandelement aus den Teilflächen 2, 3 derart mit einem Tiefenversatz t der Teilflächen 2, 3 zu versehen, daß keine Auslöschung eines auf die Teilflächen auffallenden Radarsignals erfolgt, sondern eine Umlenkung in eine unkritische Richtung. Hierbei wird das von dem Radarsender ausgestrahlte und auf das Wandelement bzw. auf die aus dem erfindungsgemäßen Wandelement 1 aufgebaute Fassade fallende Radarsignal derart umgelenkt, daß es nicht auf im Bereich der Fassade einfliegende Flugobjekte reflektiert wird, sondern in eine Richtung, die außerhalb der Einflugschneise der Flugobjekte liegt. Der Tiefenversatz der Teilflächen 2, 3 ist dabei abhängig von der Wellenlänge des Radarsignals sowie von dem Ausfallwinkel der reflektierten Radarstrahlung an den tiefenversetzten Teilflächen. Bei dieser erfindungsgemäßen Anordnung und Anwendung wird demnach verhindert, daß die an einer Gebäudefassade auftretende Reflexion der Radarstrahlung des Radarsenders auf anfliegende Flugzeuge fallen kann, so daß von diesen Flugzeugen keine ein Spiegelbild erzeugende Radarstrahlung reflektiert werden kann.

Die vorliegende Erfindung ist nicht auf die dargestellten Ausführungsbeispiele beschränkt, sondern es können diese Ausführungsbeispiele auch untereinander kombiniert werden, so daß diese Ausführungsbeispiele keine Beschränkung der Erfindung darstellen.

**Patentansprüche**

1. Reflexionsarmes Wandelement für Radarstrahlung aus mindestens n=2 oder geradzahligen Vielfachen von **n** bestehenden Teilflächen (2, 3), deren Länge und Breite größer sind als die Wellenlänge der Radarstrahlung und die zueinander einen derartigen Tiefenversatz besitzen, daß sich die von den Teilflächen reflektierten Radarsignale durch Interferenz völlig bzw. weitgehend aufheben,
   **dadurch gekennzeichnet,** daß die Teilflächen (2, 3) derart ausgebildet sind, daß sie einen gleich großen äquivalenten Radarrückstreuquerschnitt besitzen und der Tiefenversatz (t) sich berechnet aus

$$t = \frac{\lambda}{4\cos\Phi}$$

   wobei $\lambda$ die Wellenlänge der Radarstrahlung und $\Phi$ der Einfallswinkel der Radarstrahlung in der horizontalen Ebene auf die Teilflächen (2, 3) ist, und das Wandelement Bestandteil einer Gebäudefassade ist.

2. Wandelement nach Anspruch 1,
   **dadurch gekennzeichnet,** daß die reflektierenden Oberflächen der Teilflächen (2, 3) gleich groß sind.

3. Wandelement nach Anspruch 1 oder 2,
   **dadurch gekennzeichnet,** daß die reflektierenden Oberflächen der Teilflächen (2, 3) unterschiedlich groß sind.

4. Wandelement nach einem der Ansprüche 2 bis 5,
   **dadurch gekennzeichnet,** daß zwei um einen Tiefenversatz

$$t_1 = \frac{\lambda_1}{4\cos\Phi_1}$$

   zueinander versetzte, gleichgroße Teilflächen (2, 3) eine Spiegelzeile (1) bilden, wobei die Teilflächen (2, 3) die gleiche Länge und Breite besitzen.

5. Wandelement nach Anspruch 4,
   **dadurch gekennzeichnet,** daß zwei Spiegelzeilen (1) zu einer Spiegelspalte (4) mit einem Tiefenversatz $t_2$ der parallelen Teilflächen (2,2 und 3,3) der Spiegelzeilen (1) zueinander angeordnet sind, wobei

$$t_2 = \frac{\lambda_2}{4\cos\Phi_2}$$

ist und $\lambda_2$ die Wellenlänge einer zweiten Radarquelle und $\Phi_2$ der horizontale Einfallswinkel der Radarstrahlen der zweiten Radarquelle auf die Teilflächen (2, 3) ist.

6. Wandelement nach Anspruch 4,
**gekennzeichnet durch** eine Vielzahl von aneinander, übereinander und untereinander angeordneter Spiegelzeilen (1).

7. Wandelement nach Anspruch 5,
**gekennzeichnet durch** eine Vielzahl nebeneinander, über- und untereinander angeordneter Spiegelspalten (4).

8. Wandelement nach einem der Ansprüche 1 bis 7,
**dadurch gekennzeichnet,** daß die einzelnen Teilflächen (2, 3) elektrisch isoliert gegeneinander angeordnet sind.

9. Wandelement nach einem der Ansprüche 1 bis 8,
**dadurch gekennzeichnet,** daß die Teilflächen (2, 3) eine reflektierende Oberfläche aus Metall aufweisen.

10. Wandelement nach einem der Ansprüche 1 bis 9,
**dadurch gekennzeichnet,** daß die reflektierende Oberfläche als Beschichtung, Folie oder Platte ausgebildet ist.

11. Wandelement nach Anspruch 9,
**dadurch gekennzeichnet,** daß die reflektierende Oberfläche eine Gitter- oder Netzstruktur aufweist, wobei der Gitterspalt bzw. die Maschenweite $\leq \lambda/10$ ist, wobei $\lambda$ die Wellenlänge der einfallenden Radarstrahlung ist.

**Claims**

1. Low radar-beam reflection wall element comprising at least **n** = 2 or an even-numbered multiple of **n** flat panels (2,3) whose length and width are longer than the wavelength of the radar beam and which are stepped by a depth relative to one another such that the radar signals reflected from the flat panels are completely or largely extinguished by interference, **characterized in that** the flat panels (2, 3) are designed to have equally large equivalent radar back-reflection cross-sections and the stepping distance (t) between them is calculated from

$$t = \frac{\lambda}{4\cos\Phi}$$

where $\lambda$ is the wavelength of the radar beam and $\Phi$ is the angle of incidence of the radar beam in the horizontal plane upon the flat panels (2, 3), and the wall element is part of the facade of a building.

2. Wall element according to Claim 1,
**characterized in that** the reflecting surfaces of the flat panels (2, 3) are of equal size.

3. Wall element according to Claims 1 or 2,
**characterized in that** the reflecting surfaces of the flat panels (2, 3) are of different sizes.

4. Wall element according to any of Claims 2 to 5,
**characterized in that** two flat panels (2, 3) of equal size displaced apart from one another by a depth

$$t = \frac{\lambda_1}{4\cos\Phi_1}$$

form a line of reflection (1) such that the flat panels (2, 3) have the same length and width.

5. Wall element according to Claim 4,
**characterized in that** two lines of reflection are arranged relative to one another to form a reflection gap (4) with a depth displacement ($t_2$) of the parallel flat panels (2,2 and 3,3) of the lines of reflection (1) such that

$$t = \frac{\lambda_2}{4\cos\Phi_2}$$

where $\lambda_2$ is the wavelength of a second radar source and $\Phi_2$ is the horizontal angle of incidence of radar beams from the second radar source upon the flat panels (2, 3).

6. Wall element according to Claim 4,
**characterized in that** it comprises numerous lines of reflection (1) arranged adjacent to, over, or under one another.

7. Wall element according to Claim 5,
**characterized in that** it comprises numerous reflection gaps (4) arranged adjacent to, over, or under one another.

8. Wall element according to any of Claims 1 to 7,
**characterized in that**

the individual flat panels (2, 3) are electrically insulated from one another.

9.  Wall element according to any of Claims 1 to 8, **characterized in that** the flat panels (2, 3) have reflecting metallic surfaces.

10. Wall element according to any of Claims 1 to 9, **characterized in that** the reflecting surface can be a coating, foil or plate.

11. Wall element according to Claim 9, **characterized in that** the reflecting surface has a lattice or mesh structure whose lattice spacing or mesh width is $\leq \lambda/10$, where $\lambda$ is the wavelength of the incident radar beam.

## Revendications

1.  Elément de paroi minimisant les réflexions radar, composé d'au moins n=2 ou un multiple pair de n surfaces partielles (2, 3) dont la longueur et la largeur sont supérieures à la longueur d'onde du rayonnement radar et qui sont décalées en profondeur les unes par rapport aux autres de telle facon que les signaux radar réfléchis par les surfaces partielles s'annulent complètement ou dans une large mesure par interférence, **caractérisé en ce** que les surfaces partielles (2, 3) sont conformées de telle façon qu'elles présentent une section de rétrodiffusion radar équivalente identique et que le décalage en profondeur (t) se calcule à partir de

$$t = \frac{\lambda}{4 \cos \Phi}$$

où $\lambda$ est la longueur d'onde du rayonnement radar et $\Phi$, l'angle d'incidence du rayonnement radar dans le plan horizontal sur les surfaces partielles (2, 3), l'élément de paroi faisant partie d'une façade d'immeuble.

2.  Elément de paroi selon la revendication 1, caractérisé en ce que les surfaces réfléchissantes des surfaces partielles (2, 3) présentent les mêmes dimensions.

3.  Elément de paroi selon la revendication 1 ou 2, caractérisé en ce que les surfaces réfléchissantes des surfaces partielles (2, 3) présentent des dimensions différentes.

4.  Elément de paroi selon l'une des revendications 2 à 5, caractérisé en ce que deux surfaces partielles (2, 3) de dimensions égales présentant entre elles un décalage en profondeur de

$$t_1 = \frac{\lambda_1 / 4}{\cos \Phi_1}$$

forment une ligne de réflexion (1), les surfaces partielles (2, 3) ayant la même longueur et la même largeur.

5.  Elément de paroi selon la revendication 4, caractérisé en ce que deux lignes de réflexion (1) sont disposées l'une par rapport à l'autre de facon à former une colonne de réflexion (4) avec un décalage en profondeur $t_2$ des surfaces partielles parallèles (2,2 et 3,3) des lignes de réflexion (1), avec

$$t_2 = \frac{\lambda_2}{4 \cos \Phi_2}$$

où $\lambda_2$ est la longueur d'onde d'une seconde source radar, et $\Phi_2$, l'angle d'incidence horizontal des rayons radar de la seconde source radar sur les surfaces partielles (2, 3).

6.  Elément de paroi selon la revendication 4, caractérisé par une multiplicité de lignes de réflexion (1) disposées côte à côte, au-dessus et en dessous les unes des autres.

7.  Elément de paroi selon la revendication 5, caractérisé par une multiplicité de colonnes de réflexion (4) disposées côte à côte, au-dessus et en dessous les unes des autres.

8.  Elément de paroi selon l'une des revendications 1 à 7, caractérisé en ce que les différentes surfaces partielles (2, 3) sont électriquement isolées les unes des autres.

9.  Elément de paroi selon l'une des revendications 1 à 8, caractérisé en ce que les surfaces parallèles (2, 3) comportent une surface réfléchissante en métal.

10. Elément de paroi selon l'une des revendications 1 à 9, caractérisé en ce que la surface réfléchissante est réalisée sous la forme de revêtement, de feuille ou de plaque.

11. Elément de paroi selon la revendication 9, caractérisé en ce que la surface réfléchissante présente une structure de treillis ou de réseau, la fente de treillis et respectivement l'ouverture des mailles étant $\leq \lambda/10$, et $\lambda$ étant la longueur d'onde du rayonnement radar incident.

Figur 1

Figur 3

Figur 2

EP 0 446 408 B1

Figur 4

EP 0 446 408 B1

Figur 5

Schnitt A - A

Figur 6